# EUROPEAN PATENT APPLICATION

(11) **EP 2 023 696 A1**
(43) Date of publication of application: **11.02.2009**
(21) Application number: 07744143.4
(22) Date of filing: 25.05.2007
(51) Int. Cl.: H05H 1/24, B01J 19/08, F01N 3/02

(54) **ELECTRODE FOR PLASMA REACTOR VESSEL, AND PLASMA REACTOR VESSEL**

(30) Priority: 26.05.2006 JP 2006147488; 26.05.2006 JP 2006147489
(71) Applicant: Daihatsu Motor Co., Ltd., Ikeda-shi, Osaka 563-8651 (JP)
(72) Inventor: KIM, Yoonho, Gamo-gun, Shiga 520-2593 (JP); NAITO, Kazuya, Gamo-gun, Shiga 520-2593 (JP); TANAKA, Hirohisa, Ikeda-shi, Osaka 563-8651 (JP); TAN, Isao, Ikeda-shi, Osaka 563-8651 (JP); WAKUDA, Mitsuhiro, Ikeda-shi, Osaka 563-8651 (JP); OGAWA, Takashi, Gamo-gun, Shiga 520-2593 (JP)
(74) Representative: Kramer - Barske - Schmidtchen
(86) International application number: PCT/JP2007/060709
(87) International publication number: WO 2007/139020

(57) **Abstract**

[Object] To provide a plasma reactor electrode that starts discharge at a lower voltage, that is, starts plasma generation at a lower voltage, exhibits a higher plasma light emission luminance, and is thereby improved in PM (particulate matter) removal performance.

[Solution Means] A plasma reactor electrode 1 includes: a main electrode body 10; and a surface layer portion 11, coating the main electrode body 10 and having a plurality of high current densitylayers 112, made of TiO₂ having oxygen vacancies, dottedly distributed in a surface direction.

## Description

### Technical Field

The present invention relates to a plasma reactor electrode and a plasma reactor used in an apparatus for removing components contained in a smoke exhaust discharged from a factory, plant, internal combustion engine, etc., and having an adverse effect on an environment.

### Background Art

As conventional methods for reducing emission amounts of CO (carbonmonoxide), HC (hydrocarbons), NOx (nitrogen oxides), and PM (particulate matter) contained in an exhaust gas discharged, for example, from an automobile engine and particularly from a diesel engine, generally, a catalyst (including an SCR) is used for CO, HC, and NOx, and a DPF (diesel particulate filter) is used for PM. However, with a DPF, as a collection rate of PM increases, a state of poor flow of exhaust gas, that is, a state of high exhaust pressure occurs and causes lowering of engine output. To avoid this, a method of forcibly combusting and removing the accumulated PM by increasing a temperature of the exhaust gas (forced combustion) is used with a DPF. Because generally to increase the temperature of the exhaust gas, fuel is intentionally fed to the catalyst by post injection or injector injection and a reaction heat generated in this process is used, excess fuel besides that used for engine combustion is necessary and consequently, degradation of fuel consumption occurs.

As a system capable of avoiding the above issue seen with DPFs, there is known a configuration using a plasma reactor in an exhaust gas purifying apparatus including a catalyst. For example, a plasma reactor described in Patent Document 1 has a plasma inducer that generates plasma. After putting the plasma in contact with an exhaust gas, the exhaust gas is passed through a filter to make soot particles, in other words, the PM in the exhaust gas be retained in the filter and the PM is combusted by the plasma.

Meanwhile, arts of forming a plurality of protrusions on an electrode as portions at which a potential concentrates to efficiently generate plasma from the protrusions have been developed (for example, Japanese Patent Application No. 2005-292997 Specification and Japanese Patent Application No. 2005-292998 Specification).
Patent Document 1: Japanese Unexamined Patent Application Publication No. 2002-339731

### Disclosure of the Invention

### Problems to be Solved by the Invention

Here, to more reliably oxidize PM, an electrode that is lowered in consumption power and generates plasma efficiently is desired.

For this purpose, an electrode that starts discharge at a lower voltage, that is, starts plasma generation at a lower voltage is desired. Specifically, with an automobile, etc., that uses a 12-volt power supply, it is disadvantageous to generate a high voltage, and in consideration of hypothetical use in an automobile, it is advantageous to generate plasma at a lower voltage.

Also, it is known that when plasma is generated from an electrode, the plasma emits light, and presently, we found that the higher a light emission luminance in a process of plasma generation from an electrode, the greater a difference in PM removal rate between a plasma generating state and a plasma non-generating state. Thus, an electrode exhibiting a higher light emission luminance upon application of the same voltage is desirable.

The present invention has been made in view of such points and an object thereof is to provide a plasma reactor electrode made to generate plasma efficiently and thereby improved in PM removal performance.

### Means for Solving the Problems

To achieve the above object, the present invention provides the following means. That is, a plasma reactor electrode according to the present invention includes: a main electrode body; and a surface layer portion, coating the main electrode body and having a plurality of high current density layers (substance exhibiting a low work function) dottedly distributed in a surface direction.

With this configuration, due to provision of the surface layer portion having the high current density layers dottedly distributed in the surface direction, electrons are emitted readily from positions of the high current density layers when a voltage is applied. By the electrons being emitted readily from the high current density layers, it becomes possible to make corresponding portions high in plasma discharge efficiency. Specifically, in comparison to a configuration constituted solely of the main electrode body, discharge can be started at a lower voltage and the electrode can be made higher in light emission luminance.

Furthermore, to make electrons be emitted readily from the high current density layer, the surface layer portion is preferably made to include a non-conducting dielectric layer and the high current density layers. As a specific example, a configuration where the dielectric layer is an oxide having a high current density can be cited.

For favorably increasing portions that readily generate plasma and favorably combusting PM contained in an exhaust gas by making the PM be retained in the electrode for a fixed time in which the PM can be combusted, a configuration where the main electrode body is a porous structure can be cited.

To favorably form the high current density layers in the surface layer portion, the surface layer portion is preferably formed by coating on the main electrode body in a heated environment and thereafter cooling.

Furthermore, a plasma reactor according to the present invention includes: a plasma reactor electrode, comprising a main electrode body and a surface layer portion, covering the main electrode body and having a plurality of high current density layers dottedly distributed in a surface direction; and a dielectric, and the dielectric includes a main filter body, having a porous structure; and a ferroelectric surface layer, coating a surface of the main filter body.

In the present Description, a ferroelectric substance refers collectively to substances exhibiting a strongly insulating property regardless of shape. As examples of a ferroelectric substance, substances having a perovskite crystal structure, such as BT (BaTiO₃) based substances, ST (SrTiO₃) based substances, BST (Ba(Sr)TiO₃) based substances, as well as CaTiO₃, CaZrO₃, SrZrO₃, BaCeO₃, etc., PT (PbTiO₃) based substances, PLT ((Pb, La)TiO₃) based substances, PZT (Pb (Zr, Ti)O₃) based substances, TB (PbNb₂O₆) based substances, KN (KNBO₃) based substances, BSLF (bismuth layer structure; Hi₄Ti₃O₁₂) based substances, BINT (Hi(Ni, Ti)O₃) based substances, BINT-BT solid solution systems, BINT-BT-ST solid solution systems, and various other substances exhibiting a high dielectric constant can be cited.

With such a substance, a high dielectric constant can be exhibited while realizing a porous structure. Electrons can thereby be made to stay inside the filter by the strongly dielectric property without passing through pores and being conducted, and even when an exhaust gas is passed through the interior, increase of exhaust pressure can be suppressed while maintaining the plasma light emission luminance.

Among the substances cited above, a ferroelectric surface layer employing BaTiO₃, SrTiO₃, or BaSrTiO₃ can be cited as a specific example. It is considered that when any of these is employed, in addition to effectively avoiding conduction in the main filter body, a secondary electron emission effect, with which electrons are emitted in a chain-like, synergistic manner upon collision of the generated plasma with the ferroelectric substance, is induced. By the secondary electron emission effect increasing the plasma light emission luminance further, the PM can be removed effectively in a state where the exhaust gas is more activated.

### Effects of the Invention

With the plasma reactor electrode according to the present invention, by electrons being emitted readily at the high current density layers, the plasma discharge efficiency can be made high at the corresponding portions. Specifically in comparison to a configuration constituted solely of the main electrode body, discharge can be started at a lower voltage and the electrode can be made higher in light emission luminance. An electrode that is more improved in PM removal performance can thus be provided.

Furthermore, with the plasma reactor according to the present invention, the dielectric can be made to exhibit a high dielectric constant while realizing a porous structure. The exhaust gas can be passed through the interior to reduce the exhaust pressure of the plasma reactor itself while maintaining the plasma light emission luminance. The plasma reactor can thereby be made high in PM capturing performance.

### Brief Description of the Drawings

FIG. 1 is a schematic drawing of a plasma reactor according to a first embodiment of the present invention.
FIG. 2 is an explanatory diagram of principal portions of the first embodiment.
FIG. 3 is an explanatory diagram of the principal portions of the first embodiment.
FIG. 4 is a graph related to Example 1 of the present invention.
FIG. 5 is a diagram of photographs related to Example 1 of the present invention.
FIG. 6 is a schematic drawing of a plasma reactor according to a second embodiment of the present invention.
FIG. 7 is an explanatory diagram of principal portions of the second embodiment.
FIG. 8 is an explanatory diagram of the principal portions of the second embodiment.
FIG. 9 is a graph related to Example 2 of the present invention.

### Best Modes for Carrying Out the Invention

An embodiment according to the present invention shall now be described with reference to the drawings.

### <First Embodiment>

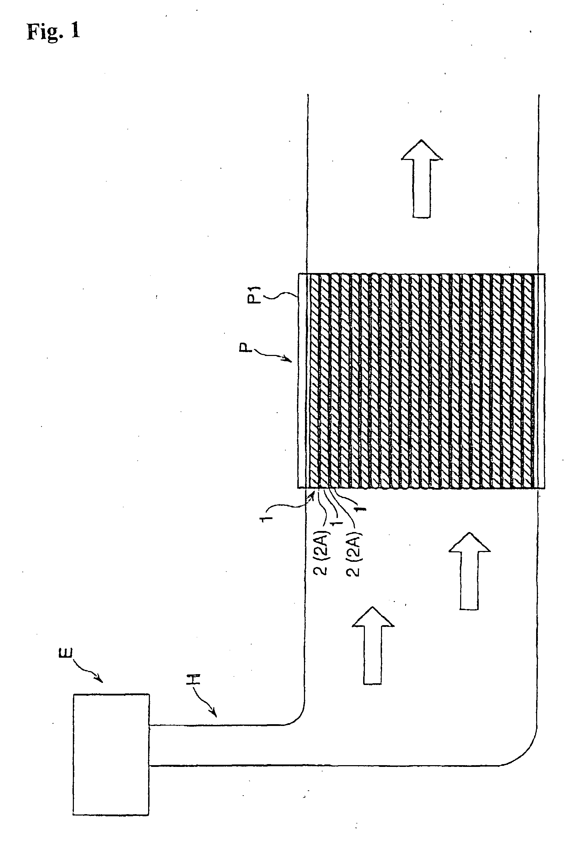

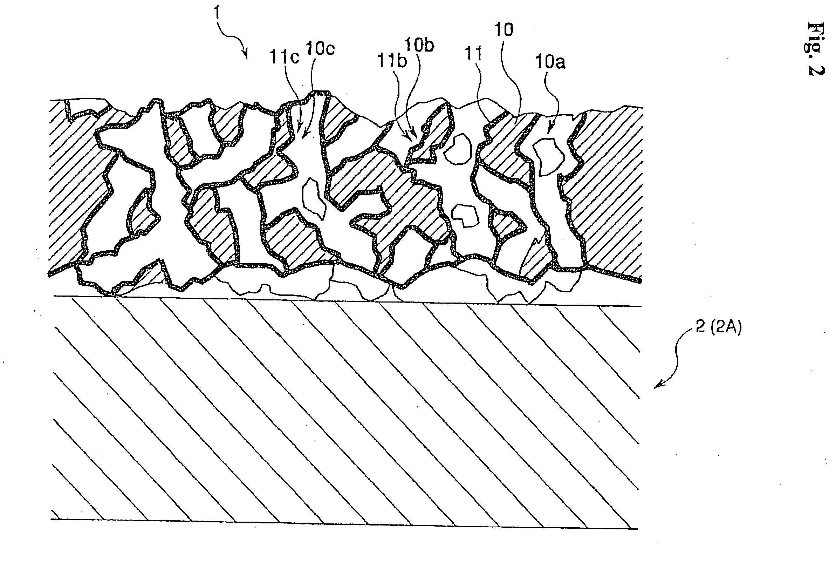

As shown in FIGS. 1 and 2, a plasma reactor P according to the present embodiment is installed in an exhaust gas flow path H through which an exhaust gas discharged, for example, from a diesel engine or other internal combustion engine E passes, and has a structure where electrodes 1 and dielectrics 2 are laminated alternately in an interior of a casing P1 of the plasma reactor P. The exhaust gas passes through along a direction indicated by arrows in which the electrodes 1 and the dielectrics 2 extend.

Each dielectric 2 is interposed between two of the electrodes 1 as shown in FIG. 1. In the first embodiment, dielectrics 2A, each constituted of a plate material, composed, for example, of alumina, is employed.

Here, each plasma reactor electrode 1 according to the present embodiment includes a main electrode body 10, and a surface layer portion 11, coating the main electrode body 10 and having a plurality of high current density layers 112 (substance exhibiting a low work function) dottedly distributed in surface directions.

A specific configuration of the electrode 1 shall now be described specifically.

As mentioned above, the electrode 1 according to the present embodiment is constituted of the main electrode body 10 and the surface layer portion 11.

As shown in FIG. 2, the main electrode body 10 has a so-called porous structure. That is, respective surfaces have shapes with which flat portions are practically non-present and have a plurality of penetrating pores 10a penetrating through at least from one surface to another surface, a plurality of recesses 10b that are depressed at the respective surfaces but do not penetrate through, and a plurality of protrusions 10c. In this case, the penetrating pores 10a do not necessarily have to be straight and may be bent or branched in a forked or triple forkedmanner, etc. The penetrating pores 10a do not necessarily have to be penetrated directly through fromone surface to another surface. It suffices that upon installation in the plasma reactor P, the exhaust gas can pass through from an upstream side to a downstream side of the electrode 1 over a time enabling plasma to sufficiently react with PM. Specifically, it is preferable to set the time in which the PM passing through the electrode 1 moves downstream while being retained or temporarily captured to exceed a time in which the plasma oxidizes and combusts the PM.

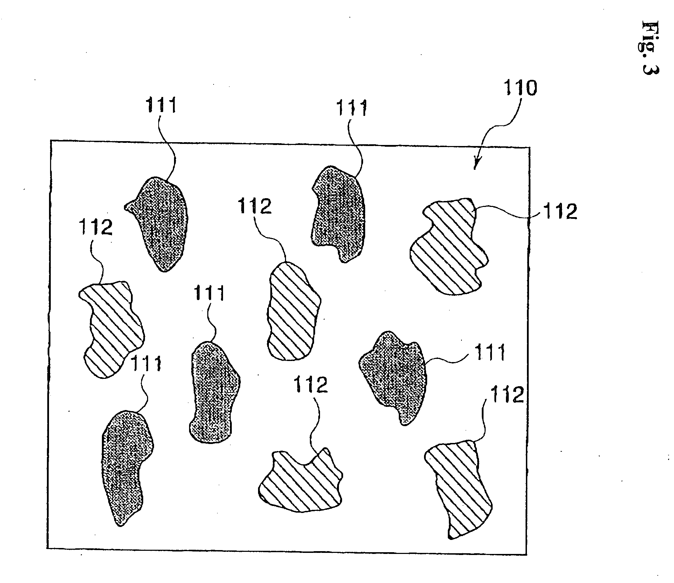

The electrode 1 according to the present embodiment has the structure where the surface layer portion 11 is coated on the main electrode body 10 as shown in FIGS. 2 and 3.

Because as shown in FIG. 2, the surface layer portion 11 coats the main electrode body 10, sites of a surface 11a of the surface layer portion 11 corresponding to the recesses 10b are surface layer recesses 11b and sites corresponding to the protrusions 10c are surface layer protrusions 11c. The surface 11a has an uneven shape with height differences formed across substantially its entirety and with the surface layer protrusions 11c being portions at which electrons are emitted readily when a voltage is applied to the electrodes 1 and capable of contributing to improving efficiency of plasma discharge.

Furthermore, as shown in FIG. 3, the surface layer portion 11 is constituted of a dielectric base layer 110, which is a dielectric layer composed of Al₂TiO₅, alumina layers 111, which are other dielectric layers distributed dottedly within the dielectric base layer 110, and high current density layers 112, composed of TiO₂ with oxygen vacancies. Specifically, by coating Al₂TiO₅, which is a ferroelectric substance, onto the main electrode body 10 in a heated environment and thereafter cooling, the surface layer portion 11 is formed so that the alumina layers 111 and the high current density layers 112 are dottedly distributed within the dielectric base layer 110. A configuration where the high current density layers 112 are dottedly distributed across substantially an entire surface of the surface layer portion 11 is thus formed.

Besides Al₂TiO₅, used in the present embodiment, BaTiO₃, SrTiO₃, Ba(Sr)TiO₃. and other ceramic materials can be cited as materials that can constitute the surface layer portion 11. BaO or SrO, which precipitates upon decomposition of such a ceramic material, and TiO₂, which has oxygen vacancies, exhibit high current densities and can constitute the high current density layers 112 of the present embodiment.

Because as shown in FIG. 3, the dielectric base layer 110 is a site composed of Al₂TiO₅, which is a ferroelectric substance, a voltage applied to the main electrode body 10 is not conducted through the dielectric base layer 110.

As shown in FIG. 3, each alumina layer 111 is a region of generally no more than 20µm diameter and is composed of Al₂O₃, in other words, alumina. A voltage applied to the main electrode body 10 is not conducted through the alumina layers 111 as well.

As shown in FIG. 3, each high current density layer 112 is a region of generally no more than 20µm diameter and is composed of TiO₂ with oxygen vacancies. Specifically, a surface of TiO₂ has many sites that are in an oxygen atom deficient state and is thus in a state where electrons can be discharged favorably from the oxygen atom deficient sites.

When a predetermined pulse voltage is applied to the electrodes 1 for the plasma reactor P having the above-described configuration, electrons flowing from each main electrode body 10 are not conducted through the dielectric base layer 110 and the aluminum layers 111 in the surface layer portion 11 but flow concentratingly through the high current density layers 112. By electrons being readily emitted from the high current density layers 112, electron emission is performed with good efficiency. Furthermore, because the main electrode body 10 has a porous structure, electrons are emitted evenmore efficiently from sites corresponding to the surface layer recesses 11c. A plasma can thus be generated at a high light emission luminance by applying a low discharge starting boosted primary voltage and increasing the applied voltage. The exhaust gas is thereby activated and the PM contained in the exhaust gas can be reduced efficiently. Furthermore, because the high current density layers 112 are dottedly distributed across substantially the entire surface of the surface layer portion 11 and are present across substantially the entire surface of the surface layer portion 11 even in the surface layer recesses 11c, the plasma can be generated substantially uniformly across substantially the entire surface of the surface layer portion 11 to enable the PM removal ability to be improved.

With the electrode 1 for the plasma reactor P according to the present embodiment, by having the above-described configuration and by provision of the surface layer portion 11 having the high current density layers 112 that are the high current density layers dottedly distributed in the surface directions, electrons are readily emitted from positions of the high current density layers 112 when a voltage is applied. By the electrons being readily emitted at the high current density layers 112, the plasma discharge efficiency can be made high. Specifically, in comparison to a configuration constituted solely of the main electrode body 10, discharge can be started even when a lower voltage is applied. In addition, when voltage of the same magnitude is applied, the plasma light emission luminance can be made higher than that in the configuration constituted solely of the main electrode body 10. Specifically, the high electron density layers 112 are dottedly distributed within the non-conducting dielectric base layer 110. To be more detailed, because the high current density layers are configured of the high current density layers 112 composed of TiO₂ with oxygen vacancies as an oxide having a high current density, electrons are made readily emitted in a favorable manner.

The alumina layers 111 composed of Al₂O₃ and the high current density layers 112 composed of TiO₂ are formed in the surface layer portion 11 through a process of coating the main electrode body 10 with Al₂TiO₅ in a heated state and thereafter cooling to decompose the Al₂TiO₅. In particular, the sites composed of TiO₂ that are formed by the above process are made sites that are in a state of being deficient in oxygen at the surface, that is, in an oxygen vacant state. These sites can thus be made high current density layers 112 that enable electrons to be emitted favorably. The alumina layers 111 and the high current density layers 112 are respectively not restricted to just Al₂O₃ and TiO₂, and may contain other substances as long as the effects of the present invention can be obtained.

In addition, because the main electrode body 10 is made to have the porous structure enabling the exhaust gas to pass through the penetrating pores and to retain the exhaust gas for a fixed time by favorably retaining or temporarily capturing the PM during passage of the exhaust gas, the plasma can be made to combust the PM, and because the PM is combusted, the PM does not become clogged inside the electrode. Consequently, pressure loss of the exhaust gas can be avoided effectively by suppressing increase of exhaust pressure of the exhaust gas and when employed, for example, in a diesel engine or other internal combustion engine E, degradation of fuel consumption and output can be prevented effectively.

### <Second Embodiment>

In a second embodiment, unlike the first embodiment, a filter 2B is used as the dielectric. Besides the dielectric, the same configuration as that of the first embodiment is employed.

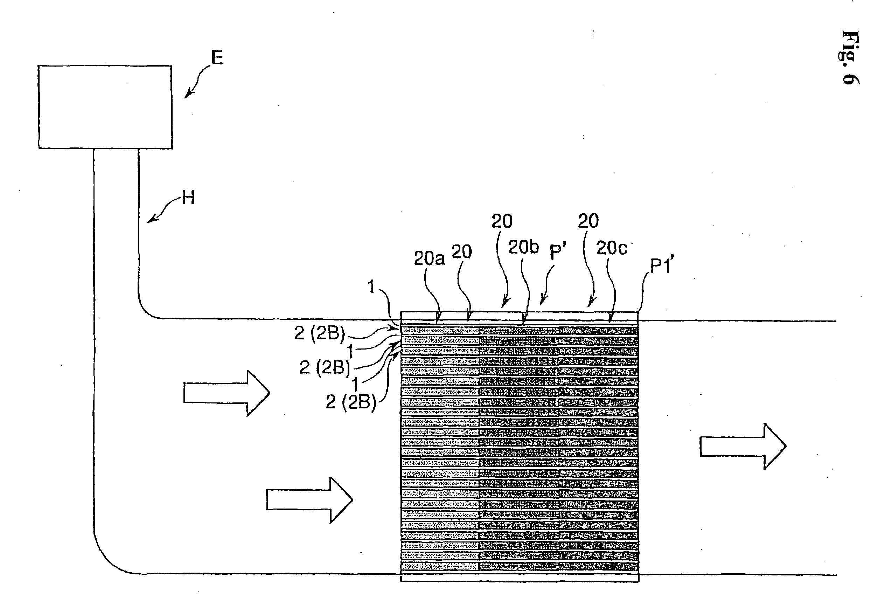

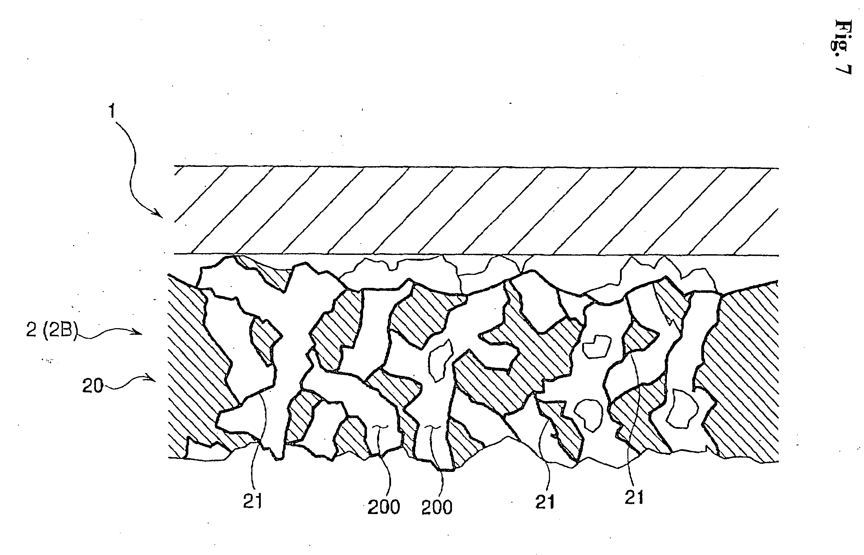

As shown in FIGS. 6 and 7, the plasma reactor P≡ according to the present embodiment has a structure where the electrodes 1 and filters 2B, to be described below, are laminated alternately in an interior of a casing P1' of the plasma reactor P'. The exhaust gas passes through in a direction indicated by arrows in which the electrodes 1 and the filters 2B extend.

As shown in FIGS. 6 and 7, a plurality of the electrodes 1 are laminated together with the filters 2B inside the exhaust gas flow path H.

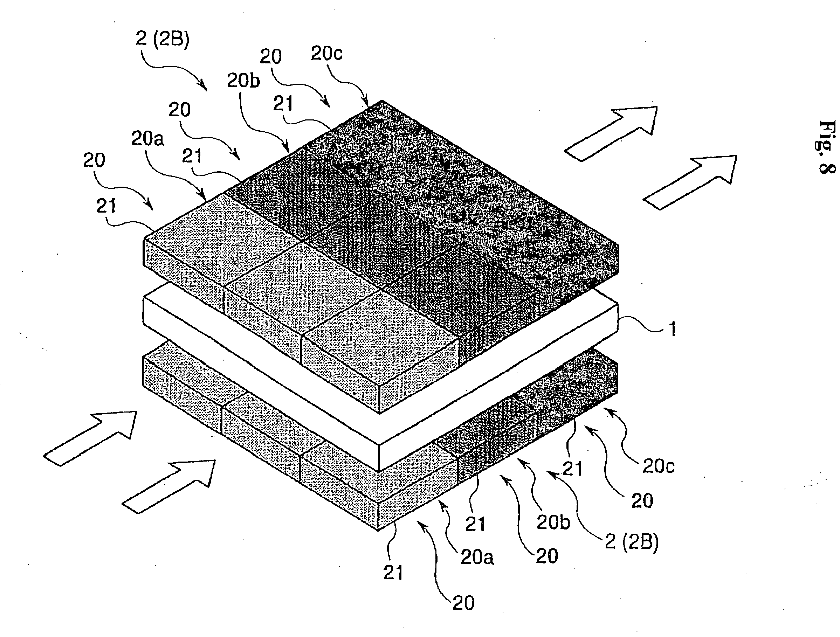

Here, as shown in FIGS. 7 and 8, the plasma reactor filter (hereinafter referred to as "filter") 2B according to the present embodiment includes a main filter body 20 having a porous structure and a ferroelectric surface layer 21 coating a surface of the main filter body 20.

A specific configuration of the filter 2B shall now be described in detail.

As shown in FIG. 7, the main filter body 20 has a porous shape made, for example, of alumina. Specifically, the main filter body has a plurality of penetrating pores 200 penetrating at least from one surface to another surface. The penetrating pores 200 do not necessarily have to penetrate directly through from one surface to another surface. It suffices that upon installation in the plasma reactor P, the exhaust gas can pass through from the upstream side to the downstream side. In this case, the penetrating pores 200 do not necessarily have to be straight and may be bent or branched in a forked or triple forked manner, etc. The penetrating pores 200 have, at inner walls thereof, uneven shapes similar to the shapes of the surfaces, and in recessed portions thereof or between the inner walls, retain or temporarily capture the PM and other matter contained in the exhaust gas to hold the PM inside the filter 2B for a fixed time sufficient to combust the PM by the plasma.

Also, as shown in FIG. 8, the main filter body 20 has three each of three separate bodies, namely, a first main body 20a, a second main body 20b, and a third main body 20c, each of, for example, square shape in planar view, aligned from the upstream side to the downstream side of the exhaust gas as indicated by arrows in the figure and thus has a total of nine separate bodies disposed so as to substantially correspond to an area of the electrode 1. By thus partitioning the main filter body 20 into the total of nine separate bodies, a possibility of mechanical destruction due to impact, etc., is reduced. In other words, a structure that is effectively difficult to destroy is realized by the main filter body 20 as a whole. Also, by configuring the first main body 20a, the second main body 20b, and the third main body 20c to increase in specific surface area in that order from the upstream side to the downstream side, the main filter body 20 is enabled to secure an effective PM capture rate. This configuration takes into consideration that by the PM being gradually oxidized and combusted at the surface by the plasma while flowing through the plasma reactor P, the PM is made gradually smaller in particle diameter as it flows from the upstream side to the downstream side. The number of partitions of the main filter body 20 and the specific surface areas of the porous structures are not restricted to the configuration shown in FIGS. 7 and 8. That is, optimal conditions for capturing the PM at a high probability and effectively securing a time for reaction of the PM and the plasma can be set as suited in adaptation to various conditions, such as the particle diameter of the PM, the exhaust pressure of the exhaust gas, etc.

As shown in FIG. 7, the ferroelectric surface layer 21 is made of a ferroelectric substance covering the entire surface of the main filter body 20, that is, the first main body 20a, the second main body 20b, and the third main body 20c.

With the present embodiment, the ferroelectric substance making up the ferroelectric surface layer 21 refers collectively to substances exhibiting a strongly insulating property regardless of shape. As examples of a ferroelectric substance, substances having a perovskite crystal structure, such as BT (BaTiO₃) based substances, ST (SrTiO₃) based substances, BST (Ba(Sr)TiO₃) based substances, as well as CaTiO₃, CaZrO₃, SrZrO₃, BaCeO₃, etc., PT (PbTiO₃) based substances, PLT ((Pb, La)TiO₃) based substances, PZT (Pb (Zr, Ti)O₃) based substances, TB (PbNb₂O₆) based substances, KN (KNBO₃) based substances, BSLF (bismuth layer structure; Bi₄Ti₃O₁₂) based substances, BINT (Bi(Ni, Ti)O₃) based substances, BINT-BT solid solution systems, BINT-BT-ST solid solution systems, and various other substances exhibiting a high dielectric constant can be cited.

In particular in the present embodiment, any of BaTiO₃, SrTiO₃, or BaSrTiO₃ is selected from among the abovementioned ferroelectric substances.

When the plasma reactor P of the above-described configuration is made to operate by application of a pulse voltage to the electrodes 1, plasma is generated by electrons discharged, in other words, emitted from the electrodes 1, and the exhaust gas passing between the electrodes 1 and the filters 2B and through the interiors of the filters 2B is thereby activated.

Here, because the ferroelectric surface layer 21 is in a state of maintaining a highly dielectric property, electrons emitted at the ferroelectric surface layer 21 generates the plasma favorably without passing through pores and being conducted. That is, electrons canbe effectively prevented from being lost from within the exhaust gas by passing through the penetrating pores 200 and being conducted to another electrode 1.

In particular, because the abovementioned BaTiO₃, SrTiO₃, or BaSrTiO₃ is employed as the ferroelectric surface layer 21, a phenomenon referred to as a secondary electron emission effect, with which, by collision of the emitted electrons with the BaTiO₃, SrTiO₃, or BaSrTiO₃, even more electrons are emitted secondarily in a chain-like, synergistic manner, occurs at high efficiency, the plasma is generated with higher light emission luminance, in other words, the exhaust gas is activated more and the PM in the exhaust gas is thus combusted favorably.

As described above, the filter 2B for the plasma reactor P' according to the present embodiment includes the main filter body 20 having the porous structure and the ferroelectric surface layer 21 coating the surface of the main filter body 20.

With this configuration, a high dielectric constant can be exhibited while realizing a porous structure. Specifically, a configuration, capable of passing the exhaust gas through its interior to reduce the exhaust pressure while maintaining the plasma light emission luminance, is made possible. That is, whereas with just the main filter body 20 made of alumina, sites are formed at which the electrons discharged from the electrode 1 pass through the penetrating pores 200 and become conducted to another electrode 1, by providing the ferroelectric surface layer 21, the conduction can be avoided effectively.

In particular, with the filter 2B according to the present embodiment, because the abovementioned BaTiO₃, SrTiO₃, or BaSrTiO₃ is employed as the ferroelectric surface layer 21, the secondary electron emission effect can be induced efficiently to achieve a high plasma light emission luminance and effectively improve the PM removal effect by the plasma.

Although the first embodiment and the second embodiment of the present invention have been described above, specific configurations of the respective portions are not limited to those of the above-described embodiments and various modifications are possible within a range not deviating from the gist of the present invention.

For example, although with each of the above-described embodiments the electrodes are made to have a porous structure, the structure and shape of the electrodes are not limited to a porous structure and electrodes of various shapes and structures may be employed. In addition, the shape, structure, and material of the dielectric are not restricted to those of alumina described above and dielectrics of any of other various structures and materials may be employed.

Besides the above, the specific configurations of the respective portions are not restricted to those of the embodiment described above and various modifications are possible within a range not deviating from the gist of the present invention.

### <Examples>

Although examples according to the present invention shall now be described, the present invention is not restricted to these examples.

### Comparative plasma light emission luminance and discharge starting voltage measurement test

### <Example 1>

### 1. <Test Material>

Example: A configuration where a conventionally-used planar electrode is coated with the surface layer portion employed in the first embodiment, that is, an electrode, having a configuration where a planar electrode is provided with the surface layer portion through a process of coating with Al₂TiO₅ in a heated state and thereafter cooling, was employed.
Comparative Example: A planar electrode of the same type as mentioned above was employed as it was in a non-coated state.

### 1-2. <Test Method>

Using a high-voltage pulse power supply with a 600Hz primary voltage being set to 100V to 300V, a 600Hz boosted secondary voltage of 2 to 6kV was applied to each electrode and the light emission luminance upon light emission due to plasma generation was measured. Also, the boosted secondary voltage at which the discharge was started was examined with each electrode.

### 1-3. <Test Results>

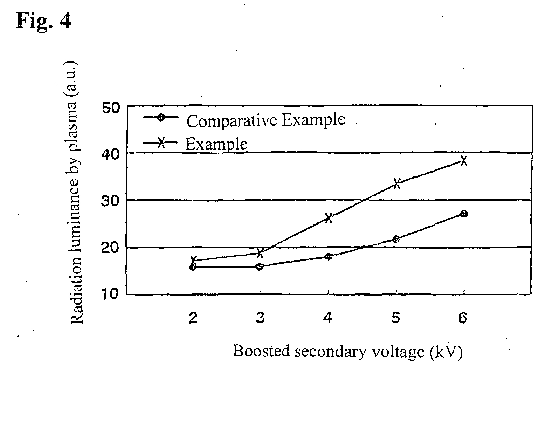

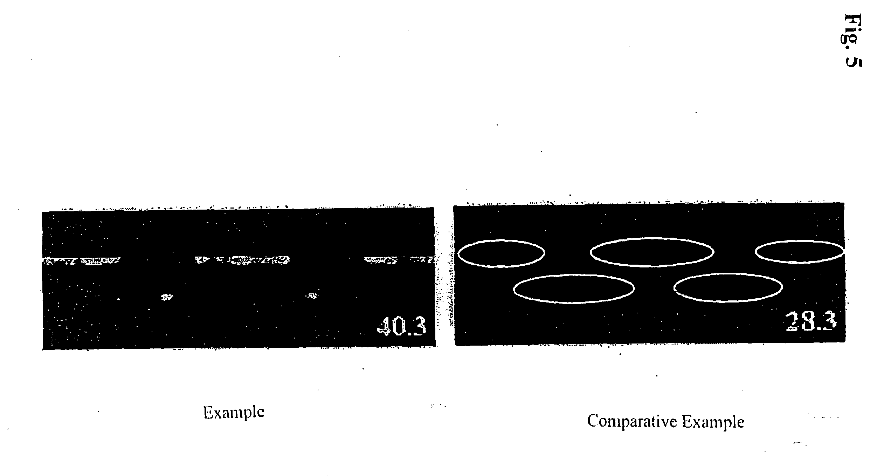

The plasma light emission luminances of the respective electrodes are shown in a graph in FIG. 4. An ordinate indicates an average of radiation luminance by plasma within a shutter speed of 1/30 seconds, and an abscissa indicates the boosted secondary voltage. As shown in the figure, the electrode of the Example exhibited a higher light emission luminance than the electrode of Comparative Example. In particular, a result that when a voltage of 6kV was applied as the boosted secondary voltage, the Example exhibited a light emission luminance of approximately 1.5 times that of the Comparative Example was obtained. FIG. 5 shows photographs of plasma light emissions upon application of a voltage of 8kV as the boosted secondary voltage. In the figure, plasma emission by the Comparative Example, though slight, occurred at locations surrounded by outlined dotted lines in the figure. A numeral at a lower right portion of each photograph is a relative value indicating the light emission luminance. Meanwhile, in regard to the discharge starting boosted secondary voltage, whereas that for the electrode of the Comparative Example was 3.2kV, that for the electrode of the Example was 1.7kV. Thus, by provision of the surface layerportion according to the first embodiment described above, the discharge starting boosted secondary voltage was reduced by approximately 45%.

With the present test, results indicating that the electrode according to the Example is higher in plasma light emission luminance and reduced in discharge starting boosted secondary voltage in comparison to the Comparative Example were obtained. Because these results are not due to the shape or structure of the electrode, the surface layer portion according to the Example is considered to provide the same effects even when applied to electrodes of various shapes.

### <Example 2>

### 2-1. <Test Material>

A plasma reactor, including an electrode, having the configuration where the surface layer portion employed in the first embodiment is coated on a porous electrode, that is, the configuration where the surface layer portion is provided through a process of coating the porous electrode with Al₂TiO₅ or BaTIO₃ in a heated state and thereafter cooling, and a dielectric, with which a porous filter is used and BaTIO₃ or SrTIO₃ employed in the second embodiment is coated on the porous main filter body, was employed.

### 2-2. <Test Method>

Using the high-voltage pulse power supply with a 1000Hz primary voltage being set to 100V to 300V, a 1000Hz boosted secondary voltage of 2 to 6kV was applied to each electrode and the light emission luminance upon light emission due to plasma generation was measured. Also, the boosted primary voltage at which the discharge was started was examined with each electrode.

### 2-3. <Test Results>

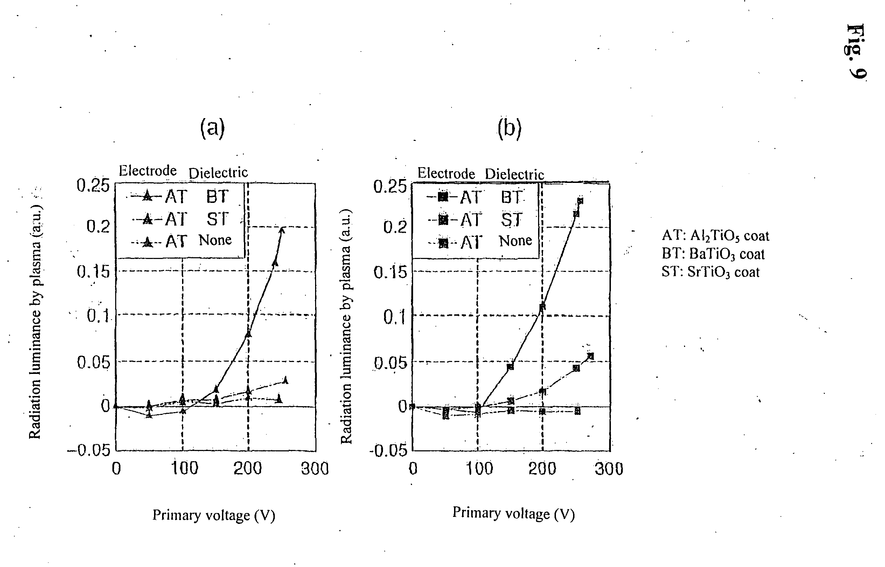

The plasma light emission luminances of the respective electrodes are shown in graphs in FIGS. 9(a) and 9(b). The ordinate indicates the average of radiation luminance by plasma within a shutter speed of 1 second, and the abscissa indicates the boostedprimary voltage. As shown in these figures, although a significant effect could not be obtained in the case where the porous electrode provided with the surface layer portion is used and the dielectric is not coated with the ferroelectric surface layer, this is considered to be due to the present measurements being made at room temperature. Because the electrodes are exposed to a high temperature in actuality and the dielectric constants of BaTIO₃ or SrTIO₃ are high when the temperature is high, it is predicted that the light emission luminance will be high when the temperature is high.
In the cases where the dielectric is coated with BaTIO₃ or SrTIO₃, higher light emission luminances were obtained in comparison to the case where coating was not performed.
With the present test, results indicating that the reactor, having the dielectric coated with a ferroelectric substance, is higher in plasma light emission luminance in comparison to that with which the dielectric is not coated with a ferroelectric substance were obtained. That is, it was confirmed that the plasma exhibits a higher light emission luminance when the configuration, where the surface layer portion employed in the first embodiment is coated on the electrode, is combined with the configuration, where the dielectric is coated with the ferroelectric surface layer.

## Claims

1. A plasma reactor electrode comprising:
a main electrode body; and
a surface layer portion that coats the main electrode body and comprises a plurality of high current density layers dottedly distributed in a surface direction.

2. The plasma reactor electrode according to Claim 1,
wherein
the surface layer portion comprises:
a dielectric layer; and
the high current density layers that is dottedly distributed within the dielectric layer.

3. The plasma reactor electrode according to Claim 1 or 2,
wherein
the high current density layer is an oxide that has a high current density.

4. The plasma reactor electrode according to Claim 1, 2, or 3,
wherein
the main electrode body has a porous structure.

5. The plasma reactor electrode according to Claim 1, 2, 3, or 4,
wherein
the surface layer portion is formed by coating on the main electrode body in a heated environment and thereafter cooling.

6. A plasma reactor comprising:
the plasma reactor electrode according to Claim 1; and
a dielectric.

7. The plasma reactor according to Claim 6,
wherein
the dielectric comprises:
a main filter body that has a porous structure; and
a ferroelectric surface layer that coats a surface of the main filter body.

8. The plasma reactor according to Claim 7,
wherein
the ferroelectric surface layer comprises BaTiO₃, SrTiO₃, or BaSrTiO₃.
